(19) Europäisches Patentamt

European Patent Office

Office européen des brevets

(11) **EP 1 708 380 A1**

(12) **EUROPÄISCHE PATENTANMELDUNG**
veröffentlicht nach Art. 158 Abs. 3 EPÜ

(43) Veröffentlichungstag:
04.10.2006 Patentblatt 2006/40

(51) Int Cl.:
*H04B 3/54* (2006.01)     *H04L 27/18* (2006.01)

(21) Anmeldenummer: 04793757.8

(22) Anmeldetag: 07.10.2004

(86) Internationale Anmeldenummer:
PCT/RU2004/000390

(87) Internationale Veröffentlichungsnummer:
WO 2005/043774 (12.05.2005 Gazette 2005/19)

(84) Benannte Vertragsstaaten:
AT BE BG CH CY CZ DE DK EE ES FI FR GB GR
HU IE IT LI LU MC NL PL PT RO SE SI SK TR

(30) Priorität: 31.10.2003 RU 2003131978

(71) Anmelder: Dis Plus Ltd.
Moscow 105484 (RU)

(72) Erfinder:
• SOKOLOV, Yuri Borisovich
  Moskovskaya obl., 141120 (RU)
• SAHAROV, Valery Viktorovich
  Nizhny Novgorod, 603137 (RU)

(74) Vertreter: Jeck, Anton
Patentanwalt,
Klingengasse 2
71665 Vaihingen/Enz (DE)

(54) **VERFAHREN ZUR GEOMETRISCHEN OBERSCHWINGUNGSMODULATION**

(57) Die Erfindung betrifft ein Verfahren zur geometrischen, harmonischen Modulation von Signalen, die aus einer Menge von voneinander äquidistanten Harmonischen bestehen. Für die Kodierung jedes Symbols der übertragenen Daten wird eine einzigartige zufällige oder pseudozufällige Menge von Anfangsphasendifferenzen der nächsten Paare der oben genannten Harmonischen verwendet und die genannten Mengen der Anfangsphasendifferenzen werden derart ausgewählt, dass der Spitzfaktor des additiven Signals minimisiert wird.

EP 1 708 380 A1

**Beschreibung**

<u>Erfindungsgebiet</u>

Die Erfindung gehört zum Gebiet der Datenerfassung und Signalgebung mittels verteilter Wechselstromnetze und kann für die langsame Datenerfassung von fernliegenden Warn- und Feuermeldeanlagen, Elektrizitätszählern und Verbrauchszählern von Wasser, Gas und Wärme verwendet werden.

<u>Stand der Technik</u>

Durch das US-Patent 5 844 949 ist ein Verbindungssystem in verteilten Wechselstromnetzen bekannt, das aus einem Sender, der ein Signal mit einer geometrischen, harmonischen Modulation aussendet, und einem Empfänger für den Empfang und die Dekodierung dieses Signals besteht. Der Hauptnachteil dieses Verbindungssystems besteht darin, dass für die Kodierung des empfangenen Signals die relative Phasenmodulation (RFM) in jeder gesendeten Harmonischen verwendet wird. Diese Bedingung erlaubt nicht, die Informationen in kleinen Mengen energiesparend zu übertragen, beispielsweise ein Bit oder ein Symbol je Sendung, da bei der Verwendung der RFM für die Übertragung eines Bits oder eines Symbols mindestens zwei Signale, nämlich ein Referenzsignal und ein Informationssignal, gesendet werden müssen.

Durch das US-Patent 6 329 905 ist auch ein Verbindungssystem in Wechselstromnetzen bekannt, dessen Sender ein Signal aussendet, das aus zwei Harmonischen mit relativer Phasemodulation zwischen ihnen besteht. Dabei sind die Frequenzen der erwähnten Harmonischen durch die Hälfte der Hauptfrequenz der Netzspannung teilbar. Der Hauptnachteil dieses Systems besteht in der offenkundig niedrigen Störfestigkeit, die dadurch bedingt ist, dass für die Datenübertragung in diesem System ein Signal verwendet wird, dessen Energie in zwei engeren Bereichen konzentriert ist, so dass das Vorhandensein der periodischen Störung, deren Frequenz zufällig mit einer der Sendefrequenzen zusammenfällt, ein solches Verbindungssystem vollständig funktionsunfähig macht. Da sich die Frequenzen der genannten Harmonischen ziemlich stark (mehrmals) voneinander unterscheiden, werden sich außerdem auch ihre relativen Phasen im Empfangspunkt stark und zufällig gegeneinander und gleichzeitig mit Fluktuationen der Frequenz- und Phasencharakteristiken der Umgebung der Signalausbreitung ändern, wodurch eine Dekodierung des Signals im Empfangspunkt unmöglich gemacht wird.

<u>Zusammenfassung der Erfindung</u>

Die Aufgabe der Erfindung besteht in der Schaffung eines Signalmodulationsverfahrens, das auf eine Datenübertragung in kleinen Mengen (beispielsweise pro Bit) innerhalb von großen Zeiträumen abgestellt ist, energiesparender als die bekannten Systeme ist und in der ungünstigsten Störumgebung und beim Vorhandensein einer starken Signaldämpfung ermöglicht, Daten von mehreren mit dem Wechselstromnetz verbundenen, langsamen Sensoren, beispielsweise Warn-und Feuermeldeanlagen, zu sammeln.

Diese Aufgabe wird bei Ausführung dieser Erfindung dadurch gelöst, dass im Unterschied zu den bekannten Verfahren eine Phasendifferenz von benachbarten, harmonischen Signalkomponenten als Modulationsobjekt verwendet wird, so dass im Vergleich zur traditionellen RFM ermöglicht wird, die Dauer des Informationssignals unter voller Wahrung der Störfestigkeitscharakteristiken des Informationssignals auf die Hälfte zu vermindern. Es sei darauf hingewiesen, dass der erwähnte Vorteil ausschließlich bei der Übertragung von kleinen Datenmengen, wie ein Bit oder ein Symbol, vorhanden ist. Für viele praktische Fälle ist es völlig ausreichend, wie beispielsweise im Falle der Auslösung eines Feuermeldesensors, auf das Warnpult nur ein Symbol zu übertragen, das die Lage des ausgelösten Sensors eindeutig identifiziert (in der Regel ist ein solches Symbol eine Bedingungsnummer oder - adresse, die dem genannten Sensor vorher zugeteilt wurde).

Die vom Anmelder vorgenommene Analyse des Stands der Technik einschließlich der Recherche nach Patenten und wissenschaftlich-technischen Informationsquellen mit dem Ziel, Quelleninformationen über Analogielösungen der vorliegenden Erfindung zu finden, haben zu dem Ergebnis geführt, dass keine Analogielösung entdeckt wurde, die durch der vorliegenden Erfindung identische Merkmale charakterisiert wird, und die Bestimmung eines Prototyps aus dem Verzeichnis der ausgesuchten Analogielösungen, die den Merkmalen der Erfindung am nächsten kommt, erlaubte, eine Gesamtheit von wesentlichen, in Bezug auf das vom Anmelder angestrebte, technische Ergebnis eigentümlichen Merkmalen bei der vorliegenden Erfindung, die im Hauptanspruch dargelegt sind, zu zeigen. Um die Erfindungshöhe der vorliegenden Erfindung zu prüfen, wurde eine zusätzliche Recherche nach bekannten Merkmalen durchgeführt, die mit den Unterscheidungsmerkmalen des Prototyps der vorliegenden Erfindung zusammenfallen. Es wurde festgestellt, dass die vorliegende Erfindung für den Fachmann aus keinem bekannten Entwicklungsstand der Technik ausdrücklich folgt, weil keine technischen Lösungen bekannt sind, in denen eine Phasendifferenz von mehreren benachbarten, harmonischen Signalkomponenten für die Signalmodulation verwendet wird.

<u>Kurzfassung der Zeichnungen</u>

Das Verfahren gemäß der vorliegenden Erfindung zur geometrischen, harmonischen Signalmodulation wird durch die folgenden Zeichnungen erläutert. Es zeigen:

Fig. 1 einen Ablaufplan des Datenerfassungssystems im Wechselstromnetz von mehreren Sensoren der Feuermeldeanlage, in dem das vorgeschlagene Modulationsverfahren verwendet wird, und

Fig. 2 ein Diagramm, das das Prinzip der Bildung der Zeitmarke der Primär-(bit)-Synchronisation zeigt.

<u>Ausführungsbeispiele der Erfindung</u>

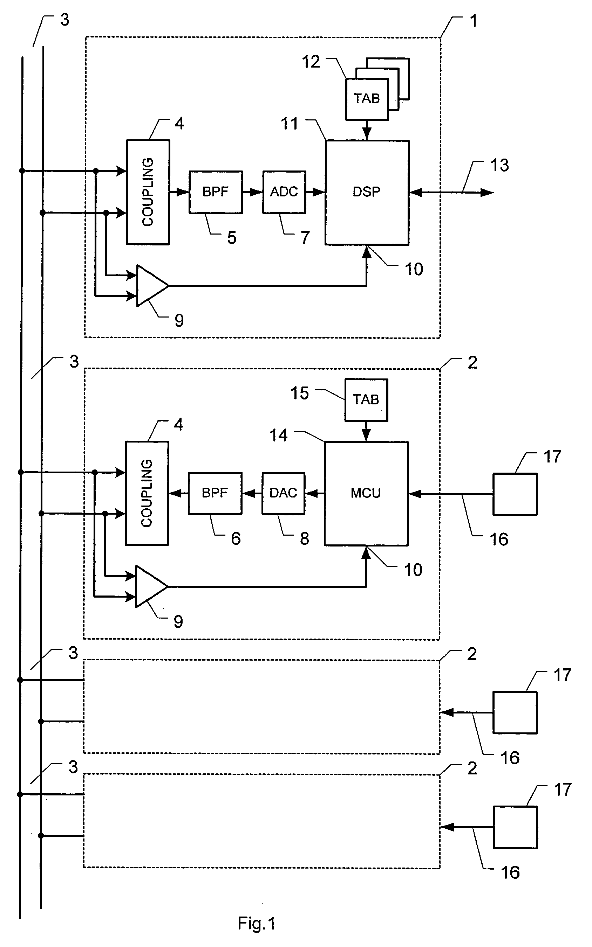

In Fig. 1 ist ein Ausführungsbeispiel der Erfindung, nämlich ein Beispiel des Datenerfassungssystems von Sensoren einer Feuermeldeanlage gezeigt. Das Datenerfassungssystem besteht aus einem Hauptblock 1 und einigen Unterblöcken 2. Alle Systemblöcke sind elektrisch mit einem Energienetz 3 verbunden. Die inneren Einrichtungen des Hauptblocks und der Unterblöcke sind ähnlich aufgebaut und weisen folgende Bestandteile auf: einen Schutz- und Signalkopplungsblock 4, Bandfilter 5 und 6, einen Analog-Digital-Umsetzer (A-D-Umsetzer) 7, einen Digital-Analog-Umsetzer (D-A-Umsetzer) 8, einen mit einer Hysterese arbeitenden Komparator 9 und einen Interrupteingang 10. Der Unterschied besteht darin, dass der Hauptblock des Systems ferner auf der Basis eines leistungsstarken Prozessors 11 für digitale Signalbearbeitung und Phasentabellen 12 ausgeführt wird, wobei der Prozessor 11 für digitale Signalbearbeitung einen Verbindungskanal 13 zur Außenwelt aufweist, und dass der einfachere und billigere Unterblock ferner auf der Basis einer Universalmikrosteuerung 14 und einer Signaltabelle 15 ausgeführt wird, wobei die Mikrosteuerung über eine Leitung mit dem Primärsensor der Feuermeldeanlage 17, beispielsweise einem Dampfdetektor, verbunden ist. Der Frequenzarbeitsbereich des Systems beträgt 20-95 kHz. Das Signal vom Unterblock wird in diesem Bereich auf 96 Harmonischen (Frequenzen, Schwingungen), die um 781,25 Hz voneinander entfernt sind, übertragen.

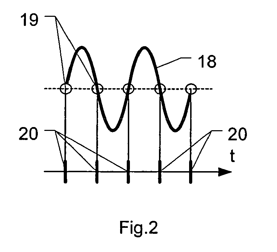

Das Datenerfassungssystem funktioniert folgendermaßen (Figuren 1 und 2): Die Komparatoren 9 bestimmen die Zeitpunkte, in denen die Netzspannung 18 der Null 19 gleich ist, und bilden dadurch eine für das ganze System synchrone Zeitmarkenfolge 20, die der Primär-(bit)-Synchronisation des Prozesses der Datenübertragung von den Unterblöcken zum Hauptblock dient. Bei der Auslösung des Primärsensors 17 beginnt die Universalmikrosteuerung 14 ihre in einem Festspeicher gespeicherte und für jeden Unterblock 2 einzigartige Signaltabelle durch den D-A-Umsetzer 8 periodisch "wiederzugeben". Die Dauer der "Wiedergabe" der Signaltabelle entspricht genau einer Halbperiode der Netzspannung, und der Anfang der "Wiedergabe" wird durch den Auslösezeitpunkt des Komparators 9 bestimmt, wobei in diesem Zeitpunkt die Netzspannung in der Leitung 3 Null ist. Das Ausgangssignal des D-A-Umsetzers 8 wird durch das Bandfilter 6 für die Beseitigung der Außerbandkomponenten abgefiltert und durch den Schutz- und Signalkopplungsblock 4 weiter zur Netzleitung 3 übertragen. Die Signaltabelle 15 ist für jeden der Unterblöcke 2 einzigartig. Mehrere Signaltabellen werden noch vor der Bildung des Datenerfassungsnetzes durch die folgende Methode synthetisiert. Mittels eines Zufallzahlen- oder Pseudozufallszahlengenerators wird eine Kandidatenmenge aus 96 Zahlen $\varphi_k$ erzeugt, die dem Intervall [0... $2\pi$] angehören. Weiter wird diese Menge zur Synthese eines Signals folgender Art verwendet:

$$s(t) = \Sigma \sin (2\pi \cdot f_m \cdot t + \varphi_m),$$

wobei m=0...95 ist und $f_m$ - 96 voneinander äquidistante Harmonische sind, die sich jeweils im Abstand von 781,25 Hz im Systemsarbeitsfrequenzband (20-95 kHz) befinden. Die Signale s(t) mit gutem Spitzfaktor und Phasensätze werden als Tabellen für die weitere Verwendung gespeichert.

Wie die Praxis zeigt, ist die Wahrscheinlichkeit genügend hoch, dass nach der gegebenen, zufälligen Menge aus 96 Phasendifferenzen ein Signal mit dem Spitzfaktor synthetisiert wird, das dem Spitzfaktor des reinen Sinus nur um 4 dB nachstehen wird. Beim Systemaufbau werden verschiedene, durch das obengenannte Verfahren ausgewählte Signaltabellen in jedem der Unterblöcke 2 aufgezeichnet. Das Sendersignal des Unterblocks läuft durch das Segment 3 des Kraftnetzes, in dem es mit Störungen kombiniert wird, sich abschwächt, verschiedenen Arten der linearen und nichtlinearen Änderungen unterzogen wird. Dieses Sendersignal gelangt in den Hauptblock 1, in dem es durch den Kopplungsblock 4 und das Bandfilter 5 läuft und im A-D-Wandler 6 digitalisiert wird. Der Digitalsignalprozessor 13 speichert alle Ausgangssignale des A-D-Wandlers, die dem angegebenen Bitintervall angehören, und lässt diese Ausgangssignale einer schnellen Fouriertransformation (FSU) unterziehen. Aus diesem Vorgang ergibt sich eine Menge von komplexen Fourierkoeffizienten, aus denen nur jene 96 Koeffizienten für die Ausführung der nachfolgenden Handlungen gebraucht werden, deren Frequenzen mit den Frequenzen zusammenfallen, auf die der Unterblock seine Daten überträgt. Diese Menge wird im Folgenden als $C_m$ bezeichnet, wobei m=0... 95 ist. Im nächsten Stadium wird ausgerechnet

$$D_\kappa = C_\kappa \cdot (C_{\kappa-1})^* \cdot \exp(- j \cdot \Delta\varphi_\kappa),$$

wobei $\Delta\varphi_k = (\varphi_k - \varphi_{k-1}, \varphi_m$ - der entsprechende, aus den Phasentabellen 12 entnommene Phasensatz, der für die Bildung der Signaltabelle des angegebenen Unterblocks verwendet wurde, k=1...95, m=0...95 ist und der Stern die komplexe Kopplung bezeichnet. Weiter wird für jeden Unterblock eine Einschätzung als Summe ausgerechnet:

$$S = \Sigma \; sign \{Re(D_k)\}.$$

Der Sinn dieser Operationen besteht darin, dass die Produkte $C_k (C_{k-1})^*$ komplexe Vektoren darstellen, deren Wendewinkel den Phasendifferenzen von benachbarten Harmonischen im Empfangssignal gleich ist, und dass die Werte $D_k$ gleiche, aber in der Richtung der gültigen Achse auf den Winkel "gewinkelte" Vektoren sind, der genau dem für die Modulation dieser Harmonischen im Sender des Unterblocks verwendeten Winkel entgegengesetzt ist. So beginnt sich die ihm entsprechende Gruppe von komplexen Zahlen $D_k$ entlang der Richtung der gültigen Achse beim Vorhandensein eines "richtigen" Signals vom Unterblock in dem gegebenen Bitintervall zu konzentrieren, und die Summe 3 zeigt eine große positive Abweichung. Wenn es im gegebenen Bitintervall kein "richtiges" Signal vom Unterblock gibt, wird die Größe S, wie leicht ersichtlich ist, eine normal verteilte Zufallgröße mit einem Null-Mittelwert und einer Mittelquadratabweichung von etwa 10 Einheiten darstellen. Die Feststellung des Signals vom gegebenen Unterblock wird mit einem Vergleich der Summe S mit einer vorher gewählten, genügend großen Grenze beendet.

Im Vergleich zum bekannten, geometrischen, harmonischen Modulationsverfahren hat dieses Signal eine zweimal kürzere Wirkungsdauer, wodurch ermöglicht wird, den Energieverbrauch des Unterblocks unter gleichzeitiger Wahrung aller Störfestigkeitscharakteristiken des Systems entsprechend zu vermindern.

Industrielle Verwertbarkeit

Die oben genannten Angaben weisen bei der Verwendung der vorliegenden Erfindung die Erfüllung folgender Bedingungen nach:

- die vorliegende Erfindung wird für die Verwendung im Bereich der Stromnetzverbindung bestimmt, insbesondere in Systemen der Datenerfassung von fernliegenden Sensoren,

- es wurde die Möglichkeit der Ausführung der vorliegenden Erfindung in der im Hauptanspruch beschriebenen Form durch die in der Anmeldung angegebenen oder bis zum Prioritätsdatum bekannten Mittel und Verfahren bestätigt,

- das Mittel, das in der Erfindung angemeldet wurde, kann das von Anmelder angestrebte, technische Ergebnis erreichen.

**Patentansprüche**

**1.** Verfahren zur geometrischen, harmonischen Modulation von Signalen, die aus einer Menge von voneinander äquidistanten Harmonischen bestehen, **dadurch gekennzeichnet, dass** für die Kodierung jedes Symbols der übertragenen Daten eine einzigartige zufällige oder pseudozufällige Menge von Anfangsphasendifferenzen der nächsten Paare der oben genannten Harmonischen verwendet wird und dass die genannten Mengen der Anfangsphasendifferenzen derart ausgewählt werden, dass der Spitzfaktor des additiven Signals minimisiert wird.

Fig.1

Fig.2

## INTERNATIONAL SEARCH REPORT

| | |
|---|---|
| International application No. |
| PCT/RU 2004/000390 |

**A. CLASSIFICATION OF SUBJECT MATTER**

H04B 3/54, H04L 27/18

According to International Patent Classification (IPC) or to both national classification and IPC

**B. FIELDS SEARCHED**

Minimum documentation searched (classification system followed by classification symbols)

H04B 3/00, 3/54, H04L 27/00, 27/18, 25/00, 25/02, 25/08, H04B 1/00, 1/02, 1/06, 1/10

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | US 5844949 A (GENERAL ELECTRIC COMPANY) 01. 12. 1998 | 1 |
| A | RU 2178952 C1 (MARTIPOSSOV VLADIMIR ERVANDOVICH et al.) 27. 01. 2002 | 1 |
| A | SU 1241518 A1 (GRINOVETSKY V.P. et al.) 30. 06. 1986 | 1 |

☐ Further documents are listed in the continuation of Box C.　　☐ See patent family annex.

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br><br>(21. 01. 2005) | Date of mailing of the international search report<br><br>(03. 02. 2005) |
|---|---|
| Name and mailing address of the ISA/<br><br>**RU**<br><br>Facsimile No. | Authorized officer<br><br><br>Telephone No. |

Form PCT/ISA/210 (second sheet) (July 1992)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5844949 A

- US 6329905 B